# EUROPÄISCHE PATENTANMELDUNG

(11) **EP 1 473 194 A1**
(43) Veröffentlichungstag der Anmeldung: **03.11.2004**
(21) Anmeldenummer: 04003925.7
(22) Anmeldetag: 20.02.2004
(51) Int. Cl.: B60R 16/02, H05K 3/00, H01Q 1/32

(54) **Integration einer elektronischen Schaltung in einem Fahrzeug**

(30) Priorität: 30.04.2003 DE 10319449
(71) Anmelder: Hirschmann Electronics GmbH & Co. KG, 72654 Neckartenzlingen (DE)
(72) Erfinder: Gelmann, Alexander, 70736 Fellbach (DE)
(74) Vertreter: Thul, Hermann, Dipl.-Phys.

(57) **Zusammenfassung**

Antenneneinrichtung (10) für ein Fahrzeug mit einer auf oder in einem Teil (1 ) des Fahrzeuges angeordneten Antennenstruktur (8) sowie ein Hochfrequenzgerät elektrischen und/oder elektronischen Bauteilen (3), die mit der Antennenstruktur (8) verbindbar sind, wobei das Hochfrequenzgerät zumindest einen Ausgang (A) aufweist, wobei erfindungsgemäß vorgesehen ist, daß Leiterbahnen (2) für die Verbindung der Bauteile (3) untereinander sowie zur Antennenstruktur (8) und/oder zu dem Ausgang (A) direkt oder unter Einlage einer Zwischenschicht auf oder in dem Teil (1) des Fahrzeuges angeordnet sind.

## Beschreibung

Die Erfindung betrifft eine elektronische Schaltung, insbesondere eine Signalverarbeitungsschaltung sowie eine Antenneneinrichtung für ein Fahrzeug gemäß den Merkmalen des Oberbegriffs des jeweiligen unabhängigen Patentanspruchs.

Aus der DE 198 23 202 A1 ist eine Antenneneinrichtung für Fahrzeuge bekannt, bei der auf einer Fahrzeugscheibe Antennenstrukturen für den Empfang von Hochfrequenzsignalen angeordnet ist. Ebenfalls ist auf der Fahrzeugscheibe ein Hochfrequenzgerät (hier ein Antennenverstärker) angeordnet, der aus verschiedenen elektrischen bzw. elektronischen Bauteilen besteht, die auf einer Leiterplatte angeordnet sind. Diese Leiterplatte wiederum ist in einem Rahmen aus Kunststoff angeordnet, wobei dieser Rahmen in geeigneter Weise auf der Fahrzeugscheibe angebracht wird. Während oder nach dem Anbringen des Hochfrequenzgerätes auf der Fahrzeugscheibe ist es erforderlich, daß eine Kontaktierung zwischen dem Eingang oder den Eingängen des Hochfrequenzgerätes und den Antennenstrukturen erfolgt. Für diese Verbindung sind schon vielfältige Vorschläge gemacht worden, die jedoch immer den Nachteil gemeinsam aufweisen, daß zum einen diese Verbindung fehleranfällig ist, so daß es zu Unterbrechungen kommen kann. Zum anderen ist es erforderlich, zwecks Kontaktierung die Kontaktfläche der jeweiligen Antennenstruktur mit der zugehörigen Kontaktfläche des Hochfrequenzgerätes in Übereinstimmung zu bringen, so daß es beim Anbringen des Hochfrequenzgerätes auf der Fahrzeugscheibe ebenfalls zu Kontaktbeeinträchtigungen oder Kontaktverlusten kommen kann, wenn die zugehörigen Kontaktflächen in ihrer Lage nicht miteinander korrespondieren. Ein weiterer Nachteil besteht in der Verwendung des Rahmens, da dieser ein zusätzliches Bauteil darstellt und somit die Kosten und Teilevielfalt erhöht.

Der Erfindung liegt daher die Aufgabe zugrunde, eine elektronische Schaltung sowie eine Antenneneinrichtung für ein Fahrzeug bereitzustellen, mit der die eingangs geschilderten Nachteile vermieden werden.

Diese Aufgabe ist durch die Merkmale des jeweiligen unabhängigen Patentanspruchs gelöst.

Erfindungsgemäß ist vorgesehen, daß die Leiterbahnen für die Verbindung der Bauteile untereinander sowie zu zumindest einem Ausgang und/oder zumindest einem Eingang der elektronischen Schaltung direkt oder unter Einlage einer Zwischenschicht auf oder in einem Teil des Fahrzeuges angeordnet sind. Dadurch ist es möglich, die Leiterbahnen in den Teil des Fahrzeuges zu integrieren und anschließend die elektrischen und/oder elektronischen Bauteile an den entsprechenden Stellen mit den Leiterbahnen zu verbinden. Somit wird eine elektronische Schaltung für ein Fahrzeug bereitgestellt, die in dem Fahrzeug direkt integriert ist, so daß zum Beispiel ein Anbauteil für das Fahrzeug vormontiert, mit den Bauteilen bestückt und geprüft werden kann, bevor es zum Anbau an das Fahrzeug selber kommt. Die Leiterbahnen, die direkt oder unter Einlage einer Zwischenschicht auf oder in einem Teil des Fahrzeuges angeordnet sind, können genauso gut zwischen den Bauteilen und einem Ausgang bzw. einem Eingang der elektronischen Schaltung vorhanden sein, so daß auch die Signalzufuhr, die Signalausgabe bzw. die Stromversorgung für die elektronische Schaltung über Leiterbahnen erfolgen kann, die in dem Teil des Fahrzeuges angeordnet sind. Damit kann beispielsweise sichergestellt werden, daß die elektronische Schaltung automatisch dann an weitere elektronische Komponenten innerhalb des Fahrzeuges angeschlossen wird, wenn daß Teil des Fahrzeuges angebaut wird. Über entsprechende Kontaktflächen, die den Eingang bzw. den Ausgang darstellen, kann die Kontaktierung zu weiteren Sensoren, Aktuatoren, weiteren elektronischen Schaltung oder Übertragungssystemen (Bussysteme) erfolgen. Diese erfindungsgemäß vorgeschlagene elektronische Schaltung kann beispielsweise derart realisiert werden, daß zunächst eine Teilschicht des Teil des Fahrzeuges hergestellt wird, wobei auf diese Teilschicht die Leiterbahnen aufgebracht und anschließend mit den Bauteilen (zum Beispiel SMD-Bauteile) verbunden werden. Nachdem dies erfolgt ist und sich somit die Bauteile auf der Zwischenschicht des Teiles des Fahrzeuges befinden, wird eine weitere Teilschicht (insbesondere Deckschicht) aufgebracht, die die Bauteile zusätzlich in ihrer Lage fixiert, die Leiterbahnen schützt (insbesondere vor Kurzschlüssen) und die geometrische Endgestaltung des Teiles des Fahrzeuges realisiert. An entsprechenden Stellen kann diese Deckschicht freibleiben, wobei über diese freibleibenden Flächen die Kontaktierung beim Anbau des Teiles des Fahrzeuges an das Fahrzeug selber erfolgt.

Erfindungsgemäß ist andererseits vorgesehen, daß nicht nur die Antennenstrukturen auf oder in einem Teil des Fahrzeuges angeordnet sind, sondern daß auch Leiterbahnen für die Verbindung der Bauteile des Hochfrequenzgerätes sowie zur Verbindung mit der Antennenstruktur und/oder einem Ausgang des Hochfrequenzgerätes direkt oder unter Einlage einer Zwischenschicht auf oder in dem Teil des Fahrzeuges angeordnet sind. Dies hat zum einen den Vorteil, daß ein Gehäuse, ein Rahmen oder dergleichen für das Hochfrequenzgerät entfallen kann, da dessen Bauteile direkt auf dem Teil des Fahrzeuges oder unter Einlage einer Zwischenschicht, die besonders flach ausgestaltet ist, angeordnet sind. Eine solche Anordnung verringert nicht nur die Teilevielfalt und damit die Kosten, sondern führt darüber hinaus auch zu einer besonders flachen Bauweise des Hochfrequenzgerätes. Dies ist gerade bei modernen Fahrzeugen, bei denen die Integrationsdichte besonders hoch ist und nur wenig Bauraum für elektronische Geräte zur Verfügung steht, besonders wichtig.

Im folgenden wird die Erfindung anhand von Ausführungsbeispielen, auf die die Erfindung jedoch nicht beschränkt ist, beschrieben und anhand der Figuren erläutert.

Es zeigen:
- Figur 1: Leiterbahnen, die direkt auf oder in dem Teil des Fahrzeuges angeordnet sind,
- Figur 2: Leiterbahnen, die unter Einlage einer Zwischenschicht auf dem Teil des Fahrzeuges angeordnet sind,
- Figur 3: Leiterbahnen und Bauteile, die von einer Schutzschicht umgeben sind,
- Figur 4: Draufsicht auf eine Antenneneinrichtung auf einem Teil des Fahrzeuges.

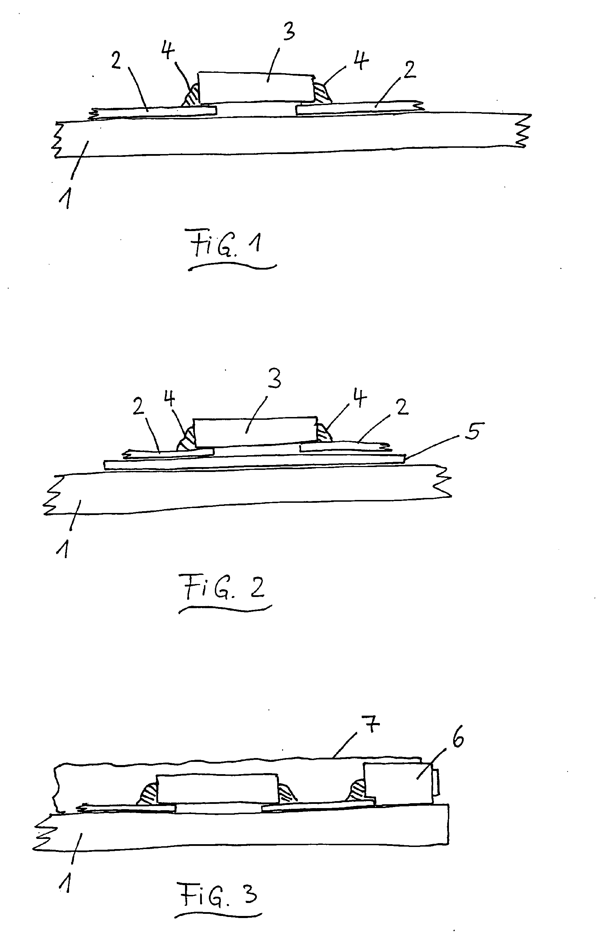

Figur 1 zeigt ausschnittsweise eine Antenneneinrichtung für ein Fahrzeug, die auf einem flächigen Teil 1 des Fahrzeuges angeordnet ist. Bei dem flächigen Teil 1 handelt es sich beispielsweise um eine Fahrzeugscheibe, wobei es sich aber auch um ein Dach, einen Kofferraumdeckel oder dergleichen sowie um sonstige in etwa flächig gestaltete Teile des Fahrzeuges (wie beispielsweise Stoßfänger oder dergleichen) handeln kann. Bei dem Ausführungsbeispiel gemäß Figur 1 sind die zur Realisierung des Hochfrequenzgerätes (wie beispielsweise ein Antennenverstärker) erforderlichen Leiterbahnen (2) direkt auf dem Teil 1 des Fahrzeuges angeordnet. Dies kann beispielsweise durch Aufdampfen, Aufkleben, MID-technisch oder dergleichen erfolgen. Genauso ist es denkbar, das flächige Teil 1 mit einer durchgehenden elektrisch leitenden Schicht zu versehen und Zwischenbereiche zwischen den späteren Leiterbahnen 2 zu entfernen. Mit den einzelnen Leiterbahnen 2 werden elektrische oder elektronische Bauteile 3 miteinander verbunden, wobei es sich bei den Bauteilen 3 beispielsweise um SMD-Bauteile, integrierte Schaltkreise, Module und dergleichen handeln kann. Die Verbindung zwischen den Leiterbahnen 2 und den Bauteilen 3 erfolgt beispielsweise in Form einer Lötverbindung 4, wobei auch andere Verbindungen (z. B. Klebeverbindungen) denkbar sind. In Figur 1 zwar nicht gezeigt, bei dem Ausführungsbeispiel aber vorhanden, sind Antennenstrukturen, die ebenfalls auf oder in dem flächigen Teil 1 des Fahrzeuges angeordnet und mit den zugehörigen Leiterbahnen 2 verbunden sind. Bezüglich einer solchen Antennenstruktur, beispielsweise auf einer Fahrzeugscheibe, kann auf die Figur 1 nebst zugehöriger Beschreibung (Spalte 6, Zeilen 26 bis 36) der DE 198 23 202 A1 verwiesen werden.

Figur 2 zeigt das Ausführungsbeispiel, bei dem die Leiterbahnen 2 nicht direkt auf oder in dem flächigen Teil 1, sondern unter Einlage einer Zwischenschicht 5 auf diesem angeordnet sind. Bei dieser Zwischenschicht 5 handelt es sich beispielsweise um eine Folie oder ein ähnliches Substrat aus dem synthetisch bzw. stofflich abgewandelten Polymer oder anderen Werkstoff, welches lösbar oder in besonders vorteilhafter Weise unlösbar mit dem Teil 1, z. B. durch Kleben, verbunden wird. Dabei ist es denkbar, daß die Leiterbahnen in der gewünschten Form schon auf dem auf dem Teil 1 anzubringenden Zwischenschicht 5 vorhanden sind oder nachträglich auf der Zwischenschicht 5 angebracht werden. Denkbar ist auch die Kombination der beiden Ausführungsbeispiele gemäß Figur 1 und Figur 2, wobei zum Beispiel zwecks Realisierung des Hochfrequenzgerätes die Bauteile 3, die für das Hochfrequenzgerät erforderlich sind, über Leiterbahnen 2 miteinander verbunden werden, die direkt auf dem flächigen Teil 1 angeordnet sind und die Verbindung zwischen den Leiterbahnen 2 des Hochfrequenzgerätes entweder zu den Antennenstrukturen und/oder zu zumindest einem Ausgang des Hochfrequenzgerätes über Leiterbahnen 2, die auf der Zwischenschicht 5 aufgebracht sind, erfolgen kann. Dabei kann es sich bei den Leiterbahnen 2, die auf der Zwischenschicht 5 angeordnet sind, um eine Flachbandleitung oder andere elektrische Verbindungen handeln. Diese Flachbandleitung bzw. elektrische Verbindung ermöglicht es beispielsweise, das Hochfrequenzgerät, z. B. mit einem Empfänger, der an einer entfernter angeordneten Stelle im Fahrzeug vorhanden ist, zu verbinden. Bei dem Ausführungsbeispiel gemäß Figur 2 kann der Übergang zwischen den Leiterbahnen 2, die auf der Zwischenschicht 5 angeordnet sind, und Leiterbahnen bzw. Antennenstrukturen, die direkt auf den Teil 1 angeordnet sind, ebenfalls über eine Lötverbindung oder eine andere dauerhafte Verbindung erfolgen.

Figur 3 zeigt ein Ausführungsbeispiel, das dem Ausführungsbeispiel gemäß Figur 1 weitestgehend entspricht, wobei aber auch das Ausführungsbeispiel gemäß Figur 2 zur Anwendung kommen kann. Bei dem in Figur 3 dargestellten Ausführungsbeispiel ist eine Steckverbindung 6 vorgesehen, die zum Beispiel einen Ausgang des Hochfrequenzgerätes darstellt, wobei diese Steckverbindung 6, insbesondere ein Gehäuse dieser Steckverbindung 6, auf oder in dem Teil 1 des Fahrzeuges integriert ist. Gleichzeitig erfolgt die elektrische Verbindung zwischen der Steckverbindung 6 und der zugehörigen Leiterbahn 2 ebenfalls über eine Lötverbindung 4 oder eine andere geeignete dauerhafte Verbindung. Weiterhin ist in Figur 3 gezeigt, daß zumindest ein Teil der Leiterbahnen 2 (vorzugsweise alle Leiterbahnen 2) bzw. ein Teil der Bauteile 3 (vorzugsweise alle Bauteile) von einer Schutzschicht 7 umgeben sind. Diese Schutzschicht 7 ist ein Bestandteil oder ein zusätzlicher Bestandteil zu dem Teil 1 des Fahrzeuges, wobei es sich beispielsweise um eine Schutzkappe, einen Verguss, eine Lackierung, eine Umspritzung oder dergleichen handeln kann. Das heißt, daß diese Schutzschicht 7 zusätzlich zu dem Teil 1 des Fahrzeuges aufgebracht wird. Dabei wird die Steckverbindung 6 mit umfaßt, kann aber gegebenenfalls ausgespart bleiben. Wichtig ist, daß mittels der Schutzschicht 7 die darunter befindlichen Bauteile und Leiterbahnen vor mechanischen Beschädigungen, Umwelteinflüssen und elektrischen Einflüssen (Kurzschlüsse beispielsweise durch Feuchtigkeit) geschützt werden. Alternativ zu einer zusätzlichen Schutzschicht 7 ist es denkbar, daß z. B. das Teil 1 aus zumindest zwei oder mehreren Schichten besteht, wobei die Leiterbahnen 2 auf einer Grundschicht des Teils 1 aufgebracht und anschließend die Bauteile 3 mit den Leiterbahnen 2 verlötet werden. Danach kann das Teil 1 durch Aufbringen einer weiteren Teilschicht oder weiteren Teilschichten fertig hergestellt werden, wobei diese zumindest eine weitere Teilschicht nicht nur die Herstellung des gesamten Teiles 1 beendet, sondern auch gleichzeitig die Funktion der Schutzschicht 7 übernimmt. Bei diesem Vorgang ist es denkbar, auf geeignete Art und Weise die Grundschicht und die zumindest eine weitere Teilschicht des Teiles 1 so auszuführen, daß auch gleichzeitig das Gehäuse der Steckverbindung 6 mit hergestellt wird.

Während bei den Figuren 1 bis 3 dargestellt ist, daß sich die Leiterbahnen 2 auf der Oberfläche des Teiles 1 befinden, ist genauso gut ergänzend oder alternativ denkbar, daß sich alle Leiterbahnen 2 oder ein Teil der Leiterbahnen 2 innerhalb des Teiles 1 befinden, also von dem nicht leitenden Material des Teiles 1 umgeben sind.

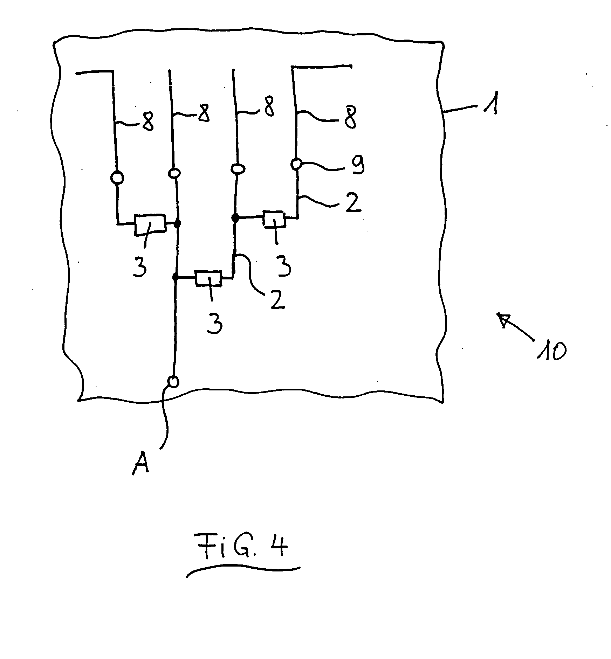

Figur 3 zeigt eine Draufsicht auf das flächige Teil 1 des Fahrzeuges, wobei erkennbar ist, daß mehrere, je nach Anwendungszweck gleiche oder voneinander verschiedene Antennenstrukturen 8 auf der Oberfläche des Teiles 1 oder darin eingebettet angeordnet sind. Diese elektrisch leitenden Antennenstrukturen 8 sind über Verbindungspunkte 9 mit Leiterbahnen 2 verbunden, wobei zwischen den Antennenstrukturen 8 und einem Ausgang A mehrere geeignete Bauteile 3 geschaltet sind, die ein Hochfrequenzgerät bilden. Die Form, Anordnung und Zahl der Leiterbahnen 2, der Bauteile 3, sowie der Antennenstrukturen 8 ist lediglich beispielhaft und soll die Anordnung der Antennenstrukturen 8 sowie der Leiterbahnen 2 auf dem Teil 1 des Fahrzeuges verdeutlichen. Die Verbindungspunkte 9 können auch weggelassen sein, so daß die Antennenstrukturen 8 direkt zu den zugenörigen Leiterbahnen 2 bzw. Bauteilen 3 führen. Die in Figur 4 dargestellte Antenneneinrichtung 10 ist somit ein unabhängig von dem Herstellungsprozeß des Fahrzeuges herstellbares Modul, wobei es sich bei dem Teil 1 beispielsweise um das Dach, den Kofferraumdeckel, ein sonstiges Anbauteil oder dergleichen, des Fahrzeuges handeln kann. Während bzw. nach Herstellung des Teiles 1 werden beispielsweise die Antennenstrukturen 8 und die Leiterbahnen 2 auf die Oberfläche des Teiles 1 aufgebracht, anschließend die Bauteile 3 mit den Leiterbahnen 2 verlötet und eine Funktionsprüfung durchgeführt. Ein solches fertiges Modul kann dann als separates Bauteil an das Band für die Komplettierung des Fahrzeuges geliefert werden.

Als weitere Ausführung ist es denkbar, die einzelnen in den Patentansprüchen genannten Varianten miteinander zu kombinieren. So ist es zum Beispiel möglich, lediglich die Aufnahmeelemente oder nur einen Teil der Aufnahmeelemente für die elektronische Schaltung in das Fahrzeugteil durch verschiedene Verfahren zu integrieren. In diesem Fall kann die Schaltung auf einem Substrat, zum Beispiel einer Leiterplatte, ausgeführt sein und anhand dieser Aufnahmeelemente an dem Fahrzeugteil befestigt werden. Die Leiterbahnen, die zu weiteren Elementen wie zum Beispiel einem Eingang, einem Ausgang, zu Sensoren, Aktuatoren oder Übertragungssystemen führen, sind dann in dem Teil des Fahrzeuges integriert und werden mit dem Substrat der elektronischen Schaltung kontaktiert, wenn diese an den Aufnahmeelementen befestigt wird. Außerdem ist es denkbar, die elektronische Schaltung bzw. das Hochfrequenzgerät nicht nur auf einem einzigen Teil des Fahrzeuges anzuordnen, sondern Bestandteile der Schaltung bzw. des Hochfrequenzgerätes auf mehrere Teile des Fahrzeuges zu verteilen und untereinander auf geeignete Art und Weise zu verbinden. Außerdem ist es denkbar, mehr als eine elektronische Schaltung bzw. mehr als ein Hochfrequenzgerät auf ein und demselben Teil des Fahrzeuges anzuordnen. Die mehreren elektronischen Schaltungen bzw. die mehreren Hochfrequenzgeräte, die auf einem einzigen Teil des Fahrzeuges oder auch auf mehreren Teilen des Fahrzeuges verteilt angeordnet sind, können voneinander entweder funktional abhängig oder unabhängig sein.

## Patentansprüche

1. Elektronische Schaltung für ein Fahrzeug, die elektrische und/oder elektronische Bauteile (3) aufweist, die über Leiterbahnen (2) miteinander verbunden sind, **dadurch gekennzeichnet, daß** die Leiterbahnen (2) für die Verbindung der Bauteile (3) untereinander sowie zu zumindest einem Ausgang A und/oder zu zumindest einem Eingang direkt oder unter Einlage einer Zwischenschicht auf oder in einem Teil des Fahrzeuges angeordnet sind.

2. Antenneneinrichtung (10) für ein Fahrzeug mit einer auf oder in einem Teil (1) des Fahrzeuges angeordneten Antennenstruktur (8) sowie ein Hochfrequenzgerät elektrischen und/oder elektronischen Bauteilen (3), die mit der Antennenstruktur (8) verbindbar sind, wobei das Hochfrequenzgerät zumindest einen Ausgang (A) aufweist, **dadurch gekennzeichnet, daß** Leiterbahnen (2) für die Verbindung der Bauteile (3) untereinander sowie zur Antennenstruktur (8) und/oder zu dem Ausgang (A) direkt oder unter Einlage einer Zwischenschicht auf oder in dem Teil (1) des Fahrzeuges angeordnet sind.

3. Antenneneinrichtung (10) nach Anspruch 1 oder 2, **dadurch gekennzeichnet, daß** die Bauteile (3) nach dem Verbinden mit den Leiterbahnen (2) von einer Schutzschicht (7) umgebbar sind.

4. Antenneneinrichtung (10) nach Anspruch 1, 2 oder 3, **dadurch gekennzeichnet, daß** die Schutzschicht (7) Bestandteil des Teiles (1) des Fahrzeuges ist oder zusätzlich dazu aufbringbar ist.

5. Antenneneinrichtung (10) nach einem der vorhergehenden Ansprüche 2 bis 4, **dadurch gekennzeichnet, daß** der Ausgang (A) des Hochfrequenzgerätes Bestandteil einer Steckverbindung (6) ist, wobei der Bestandteil der Steckverbindung (6) auf oder in dem Teil (1) des Fahrzeuges integriert ist.

6. Elektronische Schaltung nach Anspruch 1, **dadurch gekennzeichnet, daß** zumindest ein Teil von Aufnahmeelementen für die elektronische Schaltung in das Teil des Fahrzeuges integriert ist.

7. Elektronische Schaltung oder Antenneneinrichtung (10) nach einem der vorhergehenden Ansprüche, **dadurch gekennzeichnet, daß** mehrere elektronische Schaltungen und/oder mehrere Hochfrequenzgeräte auf oder in dem Teil (1) des Fahrzeuges integriert sind, die voneinander entweder funktional abhängig oder unabhängig sind.

8. Elektronische Schaltung oder Antenneneinrichtung (10) nach einem der vorhergehenden Ansprüche, **dadurch gekennzeichnet, daß** die elektronische Schaltung bzw. das Hochfrequenzgerät der Antenneneinrichtung (10) auf mehr als einem Teil (1) des Fahrzeuges angeordnet ist.
